# EUROPÄISCHE PATENTSCHRIFT

(11) **EP 0 268 558 B1**
(45) Veröffentlichungstag und Bekanntmachung des Hinweises auf die Patenterteilung: **12.05.1993**
(21) Anmeldenummer: 87810652.5
(22) Anmeldetag: 12.11.1987
(51) Int. Cl.: H03M 1/22, G01D 5/36, G01D 5/249

(54) **Längen- oder Winkelmesseinrichtung**
Apparatus for measuring lengths or angles
Appareil pour la mesure de longueurs ou d'angles

(30) Priorität: 19.11.1986 CH 624/86
(43) Veröffentlichungstag der Anmeldung: 25.05.1988
(73) Patentinhaber: Leica AG, CH-9435 Heerbrugg (CH)
(72) Erfinder: Scholian, Thomas, CH-5022 Rombach (CH)
(74) Vertreter: Stamer, Harald, Dipl.-Phys.

(56) Entgegenhaltungen:
- DE-A- 3 102 125
- DE-A- 3 311 204

## Beschreibung

Die Erfindung betrifft eine Einrichtung zur Längen-oder Winkelmessung mit einer Massverkörperung mit einer in gleiche Teilungseinheiten unterteilten ersten Inkrementalteilung, sowie weiteren, der Festlegung von auf eine Nullage bezogenen Absolutwerten dienenden Teilungen und mit einer Ablese- und Auswertevorrichtung mit einer gegenüber der Massverkörperung verschieblichen Abtastvorrichtung für die Teilungen.

Bei bekannten derartigen Messeinrichtungen erlauben unterschiedliche Ausbildungen der weiteren Teilungen die Festlegung von auf eine Nullage bezogenen Absolutwerten. So ist gemäss DE-Al-3039483 (Heidenhain GmbH) neben einer inkrementalen Gitterteilung noch eine Referenzmarkenspur und eine Codierspur vorgesehen, deren codierte Markierungen die jeweilige Referenzmarke identifizieren. DE-C 2416212 (Contraves) offenbart einen Skalenträger, der neben einer Inkrement-Skala noch eine weitere Spur mit Absolutwert-Markierungen trägt. Jede Absolutwert-Markierung hat von der nächstfolgenden einen besonderen, den Absolutwert ihres Abstandes von einer Nullstelle kennzeichnenden Abstand.

Aus der DE-A-3 102 125 (Heidenhain GmbH) ist eine inkrementale Längen- oder Winkelmeßeinrichtung bekannt, die zwei Inkrementalteilungen mit unterschiedlicher Teilungsperiode und eine Referenzteilung aufweist. Die eine Inkrementalteilung wird als Meßteilung verwendet, der die auf einen Nullpunkt bezogene Referenzteilung zugeordnet ist. An jeder Referenzmarke wird der Versatz der zweiten Inkrementalteilung gegenüber der Meßteilung bestimmt und daraus die absolute Lage der zugehörigen Referenzmarke ermittelt. Durch weitere Inkrementalteilungen mit kleineren Teilungsperioden kann die Sicherheit der Lagebestimmung der Referenzmarken und damit das Auflösungsvermögen erhöht werden. Der Aufwand für die zusätzlich anzubringenden und zu zählenden Inkrementalteilungen ist hoch.

Die DE-A-3 311 204 (Heidenhain GmbH) beschreibt eine inkrementale Längen- oder Winkelmeßeinrichtung mit nur einer Inkrementalteilung als Meßteilung. In weiteren Teilungsspuren sind Referenzmarken enthalten, die in absoluter Zuordnung zum Teilungsnullpunkt der Inkrementalteilung festgelegt sind. Die absolute Position der einzelnen Referenzmarken wird durch Codemarken gekennzeichnet, die die Absolutpositionen der zugehörigen Referenzmarke als codierte Information enthält. Die Bezugsposition ergibt sich aus dem Zählwert der Inkremente, der dem absoluten Positionswert der überfahrenen Referenzmarke überlagert wird.

In der EP-A-0 246 404 (Heidenhain GmbH) (unter Art.54(314)EPÜ) wird eine Meßeinrichtung beschrieben, bei der neben einer inkrementalen Meßteilung identische Referenzmarken vorgesehen sind, die der Meßteilung absolut zugeordnet sind und untereinander unterschiedliche Abstände aufweisen. Zur Bestimmung des Absolutwertes einer Referenzmarke werden zwei aufeinanderfolgende Abstände zwischen den beiden in Meßrichtung vorangehenden Referenzmarken und dieser Referenzmarke ermittelt. Die beiden Abstände werden durch die Abtastung der inkrementalen Teilung ermittelt. Die Referenzmarken können auch auf zwei Teilungsspuren verteilt sein, wordurch eine dichtere Aufeinanderfolge der Referenzmarken erreicht werden kann.

Aufgabe der Erfindung ist es, eine Messeinrichtung der eingangs genannten Art mit einer Massverkörperung anzugeben, welche lediglich einfache gleichabständige Teilungen aufweisen soll, aber trotzdem aufgrund einer Abtastung nur eines Teiles der gesamten Spurlänge eine Bestimmung des jeweiligen Absolutwertes wie Einrichtungen mit codierten Marken erlaubt.

Erfindungsgemäss wird zur Lösung dieser Aufgabe vorgeschlagen, dass zur Festlegung von Absolutwerten mindestens eine zweite und eine dritte, zur ersten Teilung parallele Teilung mit gleichabständigen Markierungen auf der Massverkörperung vorgesehen sind und dass die Ablese- und Auswertevorrichtung dazu bestimmt und ausgebildet ist, die jeweiligen Anzahlen von seit der Abtastung irgendeiner Markierung einer weiteren Teilung bis zur Abtastung mindestens einer nachfolgenden Markierung mindestens einer anderen weiteren Teilung in einem Zähler gezählten Teilungseinheiten der ersten Inkrementalteilung festzustellen, für diese, den Abstand der abgetasteten Markierung der weiteren Teilung von einer Nullstelle kennzeichnenden Anzahlen den zugeordneten richtigen Absolutwert zu ermitteln und daraus zusammen mit dem Zählerstand eines Zählers für die erste Inkrementalteilung den richtigen absoluten Messwert zu bestimmen.

Die zweite und dritte Teilung können so ausgebildet sein, dass sich deren Markierungsabstände um eine derartige Anzahl von Teilungseinheiten der ersten Inkrementalteilung unterscheiden, dass das Produkt aus der auf der Massverkörperung vorhandenen Gesamtanzahl der kleineren Markierungsabstände und dem Unterschied der Markierungsabstände kleiner ist, als ein halber grösserer Markierungsabstand. Dabei bestimmt die Ablese- und Auswertevorrichtung die Anzahl der Teilungseinheiten der ersten Inkrementalteilung zwischen der Abtastung je einer Markierung der zweiten oder dritten Teilung vorzeichenrichtig. Die Markierungsabstände der zweiten Teilung betragen zweckmässig ein ganzzahliges Vielfaches einer Teilungseinheit der Inkrementalteilung.

Bei einer Einrichtung mit einer photoelektrischen Abtastvorrichtung und dazu passenden Teilungen auf der Massverkörperung besteht zweckmässig jede der gleichabständigen Markierungen der zweiten und dritten Teilung aus einer Kombination von Teilstrichen, die sich über mehrere Teilungseinheiten der ersten Inkrementaleilung erstreckt, wobei die Abtastvorrichtung diesen Teilstrichkombinationen entsprechende photoelektrische Empfänger aufweist, welche beim Durchgang jeder Teilstrichkombination einen auf einen gegebenen inkrementellen Zählimpuls der ersten Inkrementalteilung zentrierten Markierungsimpuls erzeugen.

Mit Vorteil bewirkt der erste, nach Inbetriebsetzung der Messeinrichtung auftretende, von irgendeiner zweiten Teilung abgeleitete Markierungsimpuls eine Rücksetzung und Freigabe des Zählers für die erste Inkrementalteilung. Die nächstfolgenden Markierungsimpulse bewirken dann eine Uebernahme der erreichten, den Absolutwert kennzeichnenden Zählerstände in einen Zwischenspeicher, und eine Messwert-Verarbeitungsstufe ermittelt aus den im Zwischenspeicher gespeicherten Zählerständen den zugehörigen Absolutwert und aus diesem Absolutwert und den nachfolgende vom Zähler für die erste Inkrementalteilung übernommenen Zählergebnissen die auf eine Nullstelle bezogenen richtigen Messwerte.

Insbesondere bei Massverkörperungen mit grosser Gesamtlänge ist die erfindungsgemässe Längen- oder Winkelmesseinrichtung zweckmässig so ausgebildet, dass sich die Markierungsabstände der zweiten und mindestens einer weiteren Teilung unterscheiden und dass mindestens eine andere weitere Teilung die gleichen Markierungsabstände wie die zweite Teilung aufweist, jedoch mit Phasensprüngen derart, dass bestimmte Gruppen von Markierungen der zweiten Teilung durch die Abstände ihrer Markierungen von den entsprechenden Markierungen der mindestens einen anderen weiteren Teilung gekennzeichnet sind.

Die Erfindung wird nachfolgende anhand von in den Zeichnungen schematisch dargestellten Ausführungsbeispielen näher erläutert. Es zeigen
- Fig. 1: eine Anordnung von Teilungen nebst zugehöriger Abtastvorrichtung bei einer erfindungsgemässen elektrooptischen Winkelmessvorrichtung,
- Fig. 2: die Anordnung der Teilungen gemäss Fig. 1 im Detail,
- Fig. 3: die gegenseitige Lage von Teilungsmarkierungen und
- Fig. 4: ein Prinzipschema einer Ablese- und Auswertevorrichtung für eine Vorrichtung gemäss Fig. 1.

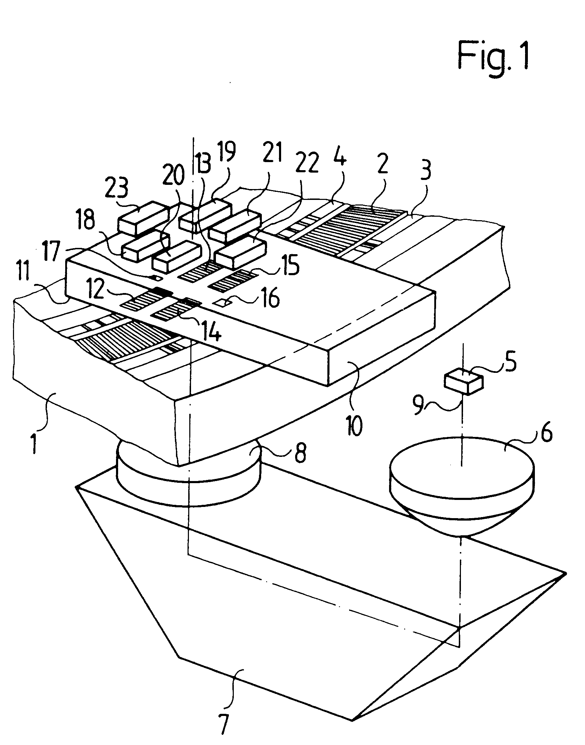

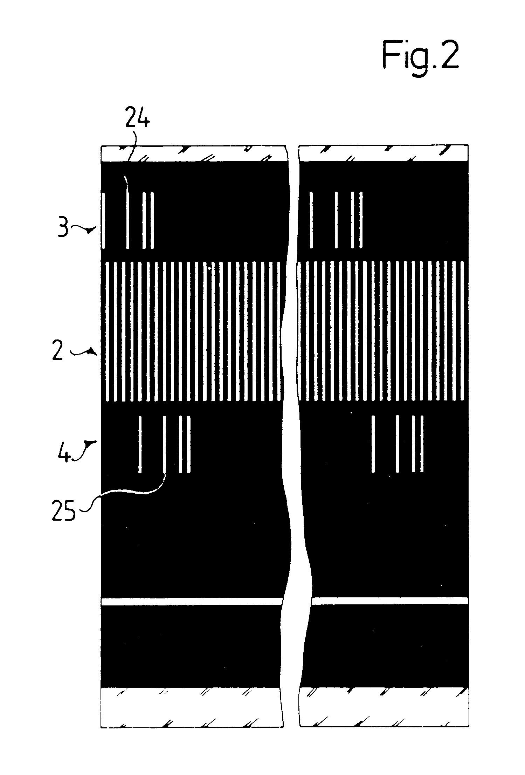

Fig. 1 zeigt einen Ausschnitt eines Teilkreises 1 als Massverkörperung eines Winkelmessgerätes. Der Teilkreis ist mit einer drehbaren Achse verbunden, deren Winkellage gemessen werden soll. Auf diesem Teilkreis sind drei Teilungen vorgesehen, nämlich eine erste Inkrementalteilung 2 und eine zweite und eine dritte Teilung 3, 4 mit gleichabständigen Markierungen, welche zu Fig. 2 genauer beschrieben werden. Zur elektrooptischen Abtastung der Kreisteilungen 2, 3 und 4 ist eine feststehende Abtastvorrichtung vorhanden. Diese umfasst eine Beleuchtungsdiode 5 oberhalb und neben dem Teilkreis 1, deren Licht von einem Kollimator 6, einem Umlenkprisma 7 und einer Beleuchtungslinse 8 in einem Beleuchtungsstrahlengang mit einer optischen Achse 9 durch den transparenten Teilkreis 1 hindurch von unten auf die opaken Kreisteilungen 2, 3, 4 geführt ist.

Oberhalb der Teilungen 2, 3, 4 und diesen dicht benachbart ist eine Abtastplatte 10 angeordnet. Diese ist transparent und auf ihrer Unterseite mit einer Abtastmaske 11 versehen. Die Abtastmaske 11 ist opak und weist zur Abtastung der Inkrementalteilung 2 vier mit Abtastgittern versehene Oeffnungen 12, 13, 14, 15 und zur Abtastung der zweiten und dritten Teilung 3, 4 zwei Oeffnungen 16, 17 auf, welche eine dem Aufbau der Teilungsmarkierungen entsprechende Struktur aufweisen. Die die Abtastplatte 10 durchdringenden Lichtströme werden von sechs photoelektrischen Empfängen 18 bis 23 aufgenommen, welche in dieser Reihenfolge den Oeffnungen 12 bis 17 zugeordnet sind.

Die Inkrementalteilung 2 weist in an sich bekannter Art eine grosse Anzahl, z.B. 4096 gleichbreite Striche und Lücken auf, wie Fig. 2 dies im einzelnen zeigt. Die Abtastgitter in den Oeffnungen 12 bis 15 entsprechen Ausschnitten aus der Inkrementalteilung 2, welche zur Teilung 2 parallel orientiert, aber untereinander phasenversetzt sind. Unterteilt man eine Periode der bei Drehung des Teilkreises 1 erfolgenden, über je eine Oeffnung 12 bis 15 gleichmässigen Helligkeitswechsel in 360 Grad, so betragen die Phasen der Oeffnungen 12 bis 15 in dieser Reihenfolge 0 Grad, 90 Grad, 180 Grad und 270 Grad. Damit haben auch die elektrischen Ausgangssignale der entsprechenden Photoempfänger 18 bis 21 bei Drehung des Teilkreises 1 die gleichen Phasen 0 Grad 90 Grad, 180 Grad, 270 Grad; sind sie sinusförmig, so lassen sie sich in bekannt Weise durch die Funktionen sin, cos, (-sin), (-cos) darstellen.

Wie in Fig. 2 dargestellt, besteht jede der gleichabständigen Markierungen der zweiten und dritten Teilung 3, 4 aus einer Kombination von Teilstrichen, die sich über mehrere Teilungseinheiten der ersten Inkrementalteilung 2 erstreckt. Immer wenn eine derartige Markierung unter einer ihr zugeordneten Maskenöffnung 16 oder 17 durchläuft, erzeugt der zugeordnete fotoelektrische Empfänger 22 oder 23 einen, auf einen von den Empfängern 18 bis 21 abgeleiteten inkrementellen Zählimpuls zentrierten Markierungsimpuls. Wie in Fig. 2 erkennbar, weisen die dargestellten Markierungen 24 und 25 der Teilungen 3 und 4 gegeneinander einen Versatz im Betrag einer ganzen Anzahl von Inkrementalintervallen auf. Der Grund hierfür liegt darin, dass die Markierungen jeder Teilung 3 und 4 zwar in sich gleichabständig sind, die Abstände der Teilung 3 sich jedoch von den Abständen der Teilung 4 um eine ganze Anzahl von Inkrementalintervallen unterscheiden.

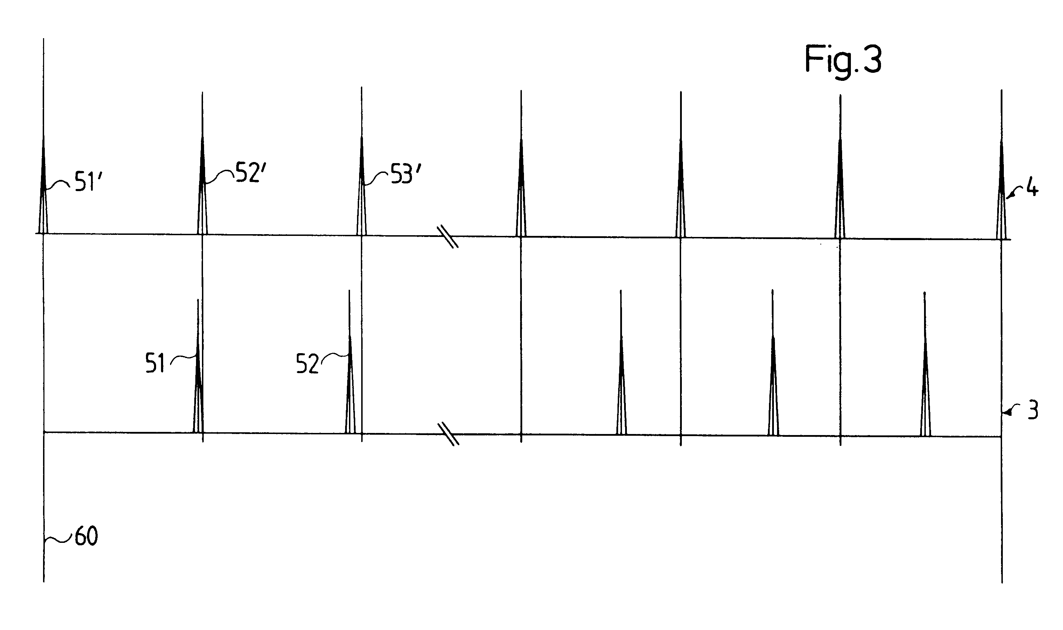

Die gegenseitige Lage der Markierungen der gesamten Teilungen 3 und 4 zeigt für das hier beschriebene Ausführungsbeispiel schematisch die Fig. 3. Hier ist durch die waagrechte Koordinatenaschse die Winkellage des Teilkreises gegenüber einem Nullpunkt 60 zwischen 0 Grad und 360 Grad bezeichnet, welche 4096 Inkrementalintervalle der Teilung 2 umfasst. Die Teilung 3 umfasst 32 Markierungen mit Abständen von 126 Inkrementalintervallen, die Teilung 4 ebenfalls 32 Markierungen mit Abständen von 128 Inkrementalintervallen. Damit ergeben sich, wie ersichtlich, aufeinanderfolgend unterschiedliche Verschiebungen zwischen den Markierungen der Teilung 3 und 4. Die Winkelbstände der beiden ersten, zweiten usw. Marken 51, 51ʹ, 52, 52ʹ usw. voneinander betragen 127, 125, 123, usw. bis 65 Inkrementalintervalle. Der Abstand einander entpsrechender Marken der gleichabständigen Teilungen 3 und 4 kennzeichnet also die Markennummer und damit den Abstand der betreffenden Marke von einer Nullstelle 60, welche in Fig. 3 am linken Ende der Teilungen 3, 4 liegt. Für diese absoluten Abstände der ersten, zweiten usw. Marke ergeben sich bei Teilung 3 127, 253, bis 4033 Inkrementalintervalle und bei Teilung 4 0, 128, 256, bis 3968 Inkrementalintervalle für die 32. Marke.

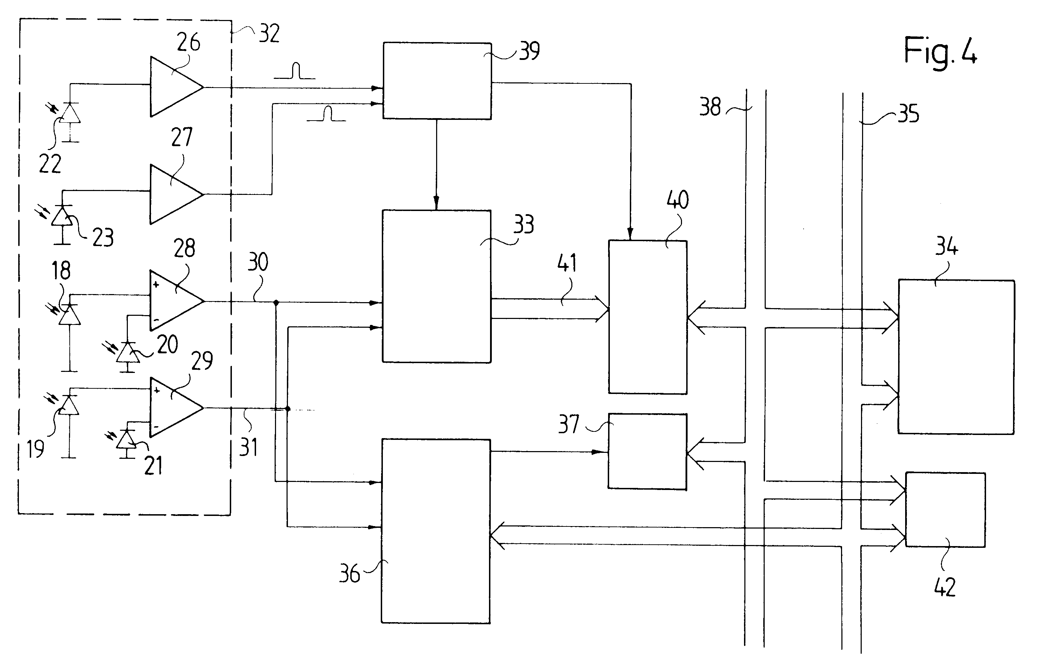

Zählt man also etwa nach dem Einschalten des Winkelmessgerätes den Abstand zwischen einer Marke der Teilung 4 und der darauffolgenden Marke der Teilung 3 in Vorwärtsrichtung zu 123 Inkrementaleinheiten, so ergibt sich daraus mittels einer geeigneten Rechenvorschrift oder Wertetafel, dass die beiden dritten Marken registriert wurden, welche Nullpunktsabstände von 256 und 379 Inkrementalintervallen haben. Die nachfolgende Inkrementalzählung an sich bekannter Art kann dann ausgehend von 256 fortgesetzt werden. Das Prinzipschema einer hierfür geeigneten Auswertevorrichtung zeigt Fig. 4. Die fotoelektrischen Empfänger 18 bis 23 gem. Fig. 1 sind hier mit zugehörigen Signalverstärkern 26 bis 29 in eine Ableseeinheit 32 zusammengefasst, welche mit der Beleuchtungsdiode 5 (Fig. 1) in einer Ebene liegt.

Die Signale der Photoempfänger 18, 20, bzw. 19, 21 sind in an sich bekannter Weise zur Ausschaltung von Gleichanteilen mit den Verstärkern 28, bzw. 29 in Differenz zu einem "Sinussignal" 30, bzw. einem "Cosinussignal" 31 mit 90 Grad Phasendifferenz zusammengeschaltet. Diese Signale 30, 31 durchlaufen bei Drehung des Teilkreises periodische Wechsel welche von einem Inkrementalzähler 33 vorzeichenrichtig gezählt werden. Zur Interpolation der Winkellage zwischen den Inkrementalimpulsen werden die Werte der Signale 30, 31 bei stillstehendem Teilkreis über einen, von einem Mikroprozessor 34 über einen Adressbus 35 gesteuerten Multiplexer 36 und einen Analog-Digitalwandler 37 über einen Daten-und Steuerbus 38 ausgelesen und als Periodenbruchteile mit den Inkrementalsummen vom Zähler 33 im Mikroprozessor 34 zum richtigen Messwert verrechnet.

Die Ausgangssignale der Photoempfänger 22, 23 gelangen über je einen Signalverstärker 26, 27 auf eine Steuerlogik 39, welche Rücksetzsignale für den Inkrementalzähler 33 und Uebertragungssignale für einen Zwischenspeicher 40 zur Uebertragung von Zählerständen aus dem Zähler 33 über einen Bus 41 in den Zähler 40 erzeugt.

Die soweit beschriebene Auswertevorrichtung hat folgende Funktion:
Nach dem Einschalten der Winkelmesseinrichtung wird zunächst der Teilkreis gedreht, bis die Ableseeinheit 32 mit dem Empfängern 22 und 23 mindestens je eine Marke der Teilungen 3 und 4 erfasst hat. Der zur zuerst erfassten Marke gehörige Signalimpuls bewirkt über die Steuerlogik 39 eine Nullsetzung des Inkrementalzählers 33, welcher sodann bis zum zweiten Signalimpuls die Inkrementalimpulse von der Teilung 2 zählt. Tritt der zweite Signalimpuls auf, so veranlasst er über die Steuerlogik 39 eine Uebernahme und Abspeicherung der momentanen Inkrementalsumme aus dem Zähler 33 in den Speicher 40, während der Zähler 33 für nachfolgende Messungen weiterzählt. Die im Speicher 40 gespeicherte Summe wird über den Steuer- und Datenbus 38 vom Mikroprozessor 34 übernommen. Dieser findet damit unter Zuhilfenahme eines Teils des Inhalts des Festwertspeichers 42 den Nullpunktsabstand der zuerst erfassten Markierung. Bei jeder folgenden Messung wird der Zählerstand rechnerisch um diesen Nullpunktsabstand korrigiert. Im oben beschriebenen Beispiel beträgt die Summe 123 und der Nullpunktsabstand 256. Die nachfolgenden Messungen werden dann durch Auswertung im Mikroprozessor 34 auf diesen Nullpunkt bezogen.

Die erfindungsgemässe Längen- oder Winkelmesseinrichtung lässt sich nicht nur in der oben beschriebenen Art zur Absolutmessung bezüglich eines Nullpunktes verwenden. Wählt man für die Markierungsabstände einer der weiteren Teilungen 3 oder 4 geeignete Vielfache eines Intervalles der Inkrementalteilung, z.B. 128, so lässt sich bei jedem Auftreten eines Markierungsimpulses einer und derselben Teilung mit einfachen elektrischen Schaltungen überprüfen, ob die Inkrementalzählung fehlerfrei arbeitet. Ferner ist es möglich, die Auswertevorrichtung mit einer programmierbaren Logik auszurüsten, welche nur die Abtastimpulse einiger, vorher ausgewählter Markierungen der weiteren Teilungen zur Signalauswertung freigibt. Durch Verwendung von mehr als zwei Markierungsspuren neben der Inkrementalteilung 2 lässt sich bedarfsabhängig die Länge der Teilung mit absolut eindeutiger Lagekennzeichnung vergrössern. Schliesslich können neben dem beschriebenen elektrooptischen Abtastsystem für Durchlicht-Teilungen auch Auflichtsysteme (z.B. mit Metallmassstäben) sowie kapazitive oder induktive Abtastverfahren verwendet werden.

Gegenüber eingangs genannten bekannten Vorrichtungen, welche die Lage einer Abtaststelle durch den Abstand von benachbarten Marken nur einer Teilung darstellen, bringt die vorliegende Lösung mit gleichabständigen Teilungen den Vorteil, dass auf einer gegebenen Massstabslänge durch eine grössere Anzahl Teilungsmarkierungen eine grössere Anzahl von Massstabspositionen absolut bestimmbar ist. Auch gegenüber anderen bekannten Vorrichtungen, welche die Lage von Codemarken durch den Aufbau der Marken selbst definieren, erlauben erfindungsgemässe Vorrichtungen Vereinfachungen, indem keinerlei Erkennungsschaltungen mit Schieberegistern o.ä. nötig sind. Es kann hier zur Festlegung der Nullpunktabstände der ohnehin zur Messung benötigte Inkrementalzähler in Verbindung mit einer einfachen Steuerlogik und einer programmierten Rechenvorschrift verwendet werden. Aufgrund der einander gleichartigen Markierungen der oben beschriebenen weiteren Teilungen 3, 4 ergeben sich auch gleichartige Markierungsimpulse, welche eine vereinfachte Auswertung erlauben.

## Patentansprüche

1. Längen- oder Winkelmesseinrichtung mit einer Massverkörperung (1) mit einer in gleiche Teilungseinheiten unterteilten ersten Inkrementalteilung (2), sowie weiteren, der Festlegung von auf eine Nullage bezogenen Absolutwerten dienenden Teilungen (3, 4) und mit einer Ablese- und Auswertevorrichtung mit einer gegenüber der Massverkörperung (1) verschieblichen Abtastvorrichtung (11 - 21) für die Teilungen, dadurch gekennzeichnet, dass zur Festlegung von Absolutwerten mindestens eine zweite und eine dritte, zur ersten Teilung (2) parallele Teilung (3, 4) mit gleichabständigen Markierungen (24, 25) auf der Massverkörperung (1) vorgesehen sind und dass die Ablese- und Auswertevorrichtung (32, 39 - 42) dazu bestimmt und ausgebildet ist, die jeweiligen Anzahlen von seit der Abtastung irgendeiner Markierung (24) einer weiteren Teilung (3) bis zur Abtastung mindestens einer nachfolgenden Markierung (25) mindestens einer anderen weiteren Teilung (4) in einem Zähler (33) gezählten Teilungseinheiten der ersten Inkrementalteilung (2) festzustellen, für diese, den Abstand der Markierung (24) der weiteren Teilung (3) von einer Nullstelle (60) kennzeichnenden Anzahlen den zugeordneten richtigen Absolutwert zu ermitteln und daraus, zusammen mit dem Zählerstand des Zählers (33) für die erste Inkrementalteilung (2) den richtigen absoluten Messwert zu bestimmen.

2. Längen- oder Winkelmesseinrichtung nach Anspruch 1, dadurch gekennzeichnet, dass sich die Markierungsabstände der zweiten und dritten Teilung (3, 4) um eine derartige Anzahl von Teilungseinheiten der ersten Inkrementalteilung (2) unterscheiden, dass das Produkt aus der auf der Massverkörperung (1) vorhandenen Gesamtanzahl der kleineren Markierungsabstände und dem Unterschied der Markierungsabstände kleiner ist, als ein halber grösserer Markierungsabstand und dass die Ablese- und Auswertevorrichtung (32, 33, 39) die Anzahl der Teilungseinheiten der ersten Inkrementalteilung (2) zwischen der Abtastung je einer Markierung der zweiten oder dritten Teilung (3, 4) vorzeichenrichtig bestimmt.

3. Längen- oder Winkel-Messeinrichtung nach Anspruch 1 oder 2 mit einer fotoelektrischen Abtastvorrichtung (11 - 21) und dazu passenden Teilungen (2, 3, 4) auf der Massverkörperung (1), dadurch gekennzeichnet, dass jede der gleichabständigen Markierungen (24, 25) der zweiten und dritten Teilung (3, 4) aus einer Kombination von Teilstrichen besteht, die sich über mehrere Teilungseinheiten der ersten Inkrementalteilung (2) erstreckt, wobei die Abtastvorrichtung diesen Teilstrichkombinationen entsprechende fotoelektrische Empfänger (16, 17, 22, 23) aufweist, welche beim Durchgang jeder Teilstrichkombination (24, 25) einen, auf einen gegebenen inkrementellen Zählimpuls der ersten Inkrementalteilung (2) zentrierten Markierungsimpuls (51, 52, 51ʹ, 52ʹ) erzeugen.

4. Längen- oder Winkelmesseinrichtung nach Anspruch 2 oder 3, dadurch gekennzeichnet, dass die Markierungsabstände der zweiten Teilung (3) ein ganzzahliges Vielfaches einer Teilungseinheit der Inkrementalteilung (2) betragen.

5. Längen- oder Winkelmesseinrichtung nach Anspruch 1 dadurch gekennzeichnet, dass sich die Markierungsabstände der zweiten (3) und mindestens einer weiteren Teilung (4) unterscheiden und dass mindestens eine andere weitere Teilung die gleichen Markierungsabstände wie die zweite Teilung (3) aufweist, jedoch mit Phasensprüngen derart, dass bestimmte Gruppen Markierungsabstände der zweiten Teilung (3) durch die Abstände ihrer Markierungen von den entsprechenden Markierungen der mindestens einen anderen weiteren Teilung gekennzeichnet sind.

6. Längen- oder Winkelmesseinrichtung nach Anspruch 2, 4 oder 5, dadurch gekennzeichnet, dass der erste, nach Inbetriebsetzung der Messeinrichtung auftretende, von irgendeiner zweiten Teilung abgeleitete Markierungsimpuls (51ʹ) eine Rücksetzung und Freigabe des Zählers (33) für die erste Inkrementalteilung (2) bewirkt, dass die nächstfolgenden Markierungsimpulse (51) eine Uebernahme der erreichten, den Absolutwert kennzeichnenden Zählerstände in einen Zwischenspeicher (40) bewirken und dass eine Messwert-Verarbeitungsstufe (34, 42) vorgesehen ist, welche aus den im Zwischenspeicher (40) gespeicherten Zählerständen den zugehörigen Absolutwert ermittelt und aus diesem Absolutwert und den nachfolgende vom Zähler (33) für die erste Inkrementalteilung (2) übernommenen Zählerergebnissen die auf eine Nullstelle (60) bezogenen richtigen Messwerte ermittelt.

## Claims

1. Equipment for measuring lengths or angles with a measure embodiment (1) with a first incremental graduation (2) divided into equal graduation units as well as further graduations (3, 4) serving the determination of absolute values related to a zero position and with a reading and evaluating device with a scanning device (11 to 21), which is displaceable relative to the measure embodiment (1), characterised thereby, that at least a second and a third graduation (3, 4), which are parallel to the first graduation (2) and have equally spaced markings (24, 25), are provided on the measure embodiment (1) for the determination of absolute values and that the reading and evaluating device (32, 39 to 42) is intended and constructed for ascertaining the respective numbers of graduation units of the first incremental graduation (2), which have been counted in a counter (33) from the scanning of any marking (24) of one further graduation (3) to the scanning of at least one subsequent marking (25) of at least one further graduation (4), ascertaining the associated correct absolute value for these numbers characterising the spacing of the marking (24) of the further graduation (3) from a zero point (60) and ascertaining the correct absolute value therefrom together with the counter state of the counter (33) for the first incremental graduation (2).

2. Equipment for measuring lengths or angles according to claim 1, characterised thereby, that the marking spacings of the second and the third graduation (3, 4) differ by such a number of graduation units of the first incremental graduation (2) that the product of the total number of the smaller marking spacings present on the measurement embodiment (1) and the difference between the marking spacings is less than half a larger marking spacing and that the reading and evaluating device (32, 33, 39) ascertains the number of the graduation units of the first incremental graduation (2) between a respective marking of the second or the third graduation (3, 4) correctly in sign.

3. Equipment for measuring lengths or angles according to claim 1 or 2 with a photo-electric scanning device (11 to 21) and graduations (2, 3, 4) appropriate thereto on the measure embodiment (1), characterised thereby, that each of the equally spaced markings (24, 25) of the second and the third graduation (3, 4) consists of a combination of part lines, which extends over several graduation units of the first incremental graduation (2), wherein the scanning device comprises photo-electric receivers (16, 17, 22, 23), which correspond with these part line combinations and on the passage of each part line combination (24, 25) generate a marking pulse (51, 52, 51', 52') centred on a given incremental counting pulse of the first incremental graduation (2).

4. Equipment for measuring lengths or angles according to claim 2 or 3, characterised thereby, that the marking spacings of the second graduation (3) amount to an integral multiple of a graduation unit of the first incremental graduation (2).

5. Equipment for measuring lengths or angles according to claim 1, characterised thereby, that the marking spacings of the second graduation (3) and of at least one further graduation (4) differ and that at least one other further graduation displays the same marking spacings as the second graduation (3), however with phase steps in such a manner that certain groups of marking spacings of the second graduation (3) are distinguished by the spacings of their markings from the corresponding markings of the at least one other further graduation.

6. Equipment for measuring lengths or angles according to claim 2, 4 or 5, characterised thereby, that the first marking pulse (51'), which occurs after the measuring equipment has been put into operation and is derived from any second graduation, causes a resetting and release of the counter (33) for the first incremental graduation (2), that the next following marking pulses (51) cause a take-over of the reached counter states characterising the absolute value into an intermediate storage device (40) and that a measurement value processing stage (34, 42) is provided, which ascertains the associated absolute value from the counter states stored in the intermediate storage device (40) and the correct measurement values referred to a zero point (60) from this absolute value and the counting results subsequently taken over from the counter (33) for the first incremental graduation (2).

## Revendications

1. Appareil pour la mesure de longueurs ou d'angles comprenant une mesure matérialisée (1) avec une première graduation incrémentielle (2) répartie en des unités de graduation égales, ainsi que d'autres graduations (3, 4) servant à définir des valeurs absolues se rapportant à une position zéro, et un dispositif de lecture et d'exploitation comprenant un dispositif de balayage (11-21) déplaçable relativement à la mesure matérialisée (1) pour les graduations, caractérisé en ce que sont prévues pour la définition de valeurs absolues au moins une deuxième et une troisième graduation (3, 4) parallèle à la première graduation (2) avec des marquages (24, 25) espacés régulièrement sur la mesure matérialisée (1), et en ce que le dispositif de lecture et d'exploitation (32, 39-42) est destiné et réalisé pour définir ou constater les nombres respectifs d'unités de graduation de la première graduation incrémentielle (2) comptés dans un compteur (33), depuis le balayage de n'importe quel marquage (24) d'une autre graduation (3) jusqu'au balayage au moins d'un marquage suivant (25) au moins d'une autre graduation supplémentaire (4), de déterminer pour ces nombres caractérisant l'espacement des marquages (24) de la graduation supplémentaire (3) d'un emplacement ou point zéro (60) la valeur absolue exacte associée et de définir à partir de celle-ci, conjointement avec la position du compteur (33) la valeur de mesure absolue exacte pour la première graduation incrémentielle (2).

2. Appareil pour la mesure de longueurs ou d'angles selon la revendication 1, caractérisé en ce que les espacements de marquage de la deuxième et troisième graduation (3, 4) se distinguent d'un nombre d'unités de graduation de la première graduation incrémentielle (2) tel que le produit constitué du nombre total présent sur la mesure matérialisée des espacements de marquage plus petits et la différence des espacements de marquage est plus petit qu'un demi-espacement de marquage plus grand, et en ce que le dispositif de lecture et d'exploitation (32, 33, 39) définit par un signe exact le nombre des unités de graduation de la première graduation incrémentielle (2) entre le balayage d'un marquage respectivement de la deuxième ou troisième graduation (3, 4).

3. Dispositif pour la mesure de longueurs ou d'angles selon la revendication 1 ou 2, comprenant un dispositif de balayage photo-électrique (11-21) et des graduations appropriées (2, 3, 4) sur la mesure matérialisée (1), caractérisé en ce que chacun des marquages espacés régulièrement (24, 25) de la deuxième et troisième graduation (3, 4) est constitué d'une combinaison de traits de graduation qui s'étendent sur plusieurs unités de graduation de la première graduation incrémentielle (2), le dispositif de balayage présentant des récepteurs photo-électriques (16, 17, 22, 23) correspondant à ces combinaisons de traits de graduation et qui produisent lors du passage de chaque combinaison de traits de graduation (24, 25) une impulsion de marquage (51, 52, 51', 52'), centrée sur une impulsion de comptage incrémentielle donnée de la première graduation incrémentielle (2).

4. Appareil pour la mesure de longueurs ou d'angles selon la revendication 2 ou 3, caractérisé en ce que les espacements de marquage de la deuxième graduation (3) représentent un multiple entier d'une unité de graduation de la graduation incrémentielle (2).

5. Appareil pour la mesure de longueurs ou d'angles selon la revendication 1, caractérisé en ce que les espacements de marquage de la deuxième (3) et au moins d'une autre graduation (4) sont différents, et en ce qu'au moins une autre graduation supplémentaire présente les mêmes espacements de marquage que la deuxième graduation (3), cependant avec des changements brusques de phase de telle sorte que des groupes définis d'espacement de marquage de la deuxième graduation (3) sont caractérisés par les espacements de leurs marquages des marquages correspondants de cette autre graduation supplémentaire au moins.

6. Appareil pour la mesure de longueurs ou d'angles selon la revendication 2, 4 ou 5, caractérisé en ce que la première impulsion de marquage (51') se produisant après la mise en fonctionnement de l'appareil de mesure, dérivée de n'importe quelle deuxième graduation provoque une remise à l'état initial et une libération du compteur (33) pour la première graduation incrémentielle (2), en ce que les impulsions de marquage suivantes (51) provoquent une reprise des états de comptage obtenus caractérisant la valeur absolue dans une mémoire intermédiaire (40), et en ce qu'il est prévu un étage de traitement de valeurs de mesure (34, 42) qui détermine à partir des états de compteurs stockés dans la mémoire intermédiaire (40) la valeur absolue associée et détermine à partir de cette valeur absolue et des résultats de compteurs repris ensuite par le compteur (33) pour la première graduation incrémentielle (2), les valeurs de mesure exactes se rapportant à un point zéro (60).
